# EUROPEAN PATENT SPECIFICATION

(11) **EP 0 774 757 B1**
(45) Date of publication and mention of the grant of the patent: **26.11.2003**
(21) Application number: 96307949.6
(22) Date of filing: 01.11.1996
(51) Int. Cl.: G11C 7/00, G11C 11/419

(54) **Precharge circuit for a semiconductor memory device**
Vorladungsschaltung für eine Halbleiterspeicheranordnung
Circuit de précharge pour un dispositif de mémoire à semi conducteurs

(30) Priority: 03.11.1995 KR 3961695
(43) Date of publication of application: 21.05.1997
(73) Proprietor: Samsung Electronics Co., Ltd., Suwon City, Kyungki-do (KR)
(72) Inventor: Kwon, Kook-Hwan, Suwon-city, Kyungki-do (KR); Park, Hee-Choul, Paldal-gu, Suwon-city, Kyungki-do (KR)
(74) Representative: Tunstall, Christopher Stephen

(56) References cited:
- EP-A- 0 608 967
- US-A- 4 802 129
- US-A- 5 121 356

## Description

### Background to the Invention

The present invention concerns a data line precharge circuit for a semiconductor memory device.

It is known to be desirable to achieve high speed operation of highly integrated semiconductor memory devices. The data processing speed of the semiconductor memory devices depends on the bit line sensing operation when reading data from the memory cells, directly affecting the access speed of the data. When the semiconductor memory device is in read mode, the bit lines are precharged so as to allow the data to be rapidly sensed. However, in write mode, the bit lines have large voltage differences, so that a given time is required to precharge the bit lines in the next read mode, thus decreasing the data access speed. In addition, data access speed depends on the speed at which the voltage differences between the data lines are produced, represented by the time required to raise the voltage of the data lines from the precharge state to a given level.

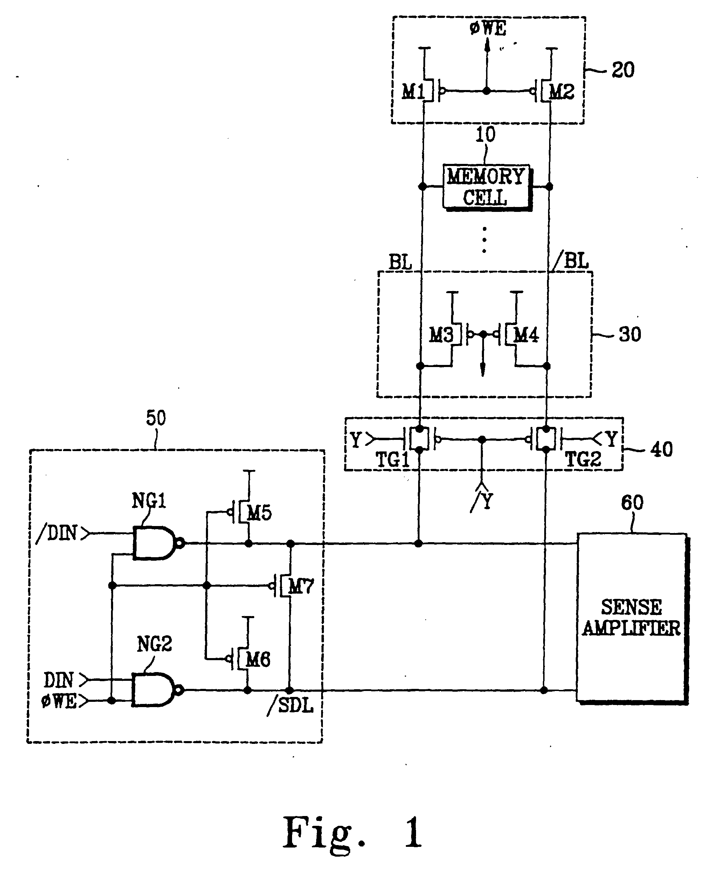

Referring to Fig. 1 which illustrates the structure of the bit lines of a conventional semiconductor memory device, the memory cell is connected between the bit lines BL and /BL. A first precharge circuit 20 is connected between the source voltage and bit lines BL and /BL and its control terminals are connected to a write control signal φWE. The first precharge circuit 20 comprises two PMOS transistors M1 and M2 respectively connected between the source voltage and the bit lines BL and /BL with the gates connected to the write control signal φWE to precharge the respective bit lines BL and /BL. The PMOS transistors switch to precharge the bit lines BL and /BL with the source voltage in the read mode when the write control signal φWE is disabled.

A second precharge circuit 30 is connected between the source voltage and bit lines BL and /BL with control terminal connected to ground voltage to precharge the bit lines BL and /BL. The second precharge circuit 30 comprises two PMOS transistors M3 and M4 respectively connected between the source voltage and the bit lines BL and /BL with their gates connected to ground voltage so as to precharge the respective bit lines BL and /BL. This circuit 30 always precharges the bit lines BL and /BL with the source voltage.

A column gate circuit 40 is connected between the bit lines BL and /BL and the data lines SDL and /SDL gated by a column select signal "Y" to connect the bit lines with the data lines. The column gate circuit 40 comprises first and second transfer gates TG1 and TG2 respectively connected between the bit lines BL and /BL and the data lines SDL and /SDL. The column gate circuit 40 is switched by the column select signal "Y" to connect the bit lines BL and /BL from the data lines SDL and /SDL so as to form a signal path between the memory cell 10 and an external input/output pad.

A write and precharge circuit 50 has to transfer external input data DIN and /DIN to the data lines SDL and /SDL in response to the write control signal φWE. The write and precharge circuit 50 includes two NAND gates NG1 and NG2 for respectively operating the input data DIN and /DIN with the write control signal φWE. The NAND gates NG1 and NG2 apply the external input data DIN and /DIN to the data lines SDL and /SDL on activation of the write control signal φWE to a high level.

Also included are two PMOS transistors M5 and M6 respectively connected between the source voltage and data lines SDL and /SDL with their gates connected to the write control signal φWE, and another PMOS transistor M7 connected between the data lines SDL and /SDL with its gate connected to the write control signal φWE. The PMOS transistors M5 and M6 precharge the respective data lines SDL and /SDL with the source voltage in the read mode where the write control signal φWE is deactivated to a low level while the PMOS transistor M7 equalizes the voltages of the data lines SDL and /SDL precharged in the read mode. The sense amplifier 60 amplifies the data of the data lines SDL and /SDL output to the input/output pad.

Describing the data access operation of such a conventional semiconductor memory device, the write control signal φWE is activated to high logic level in the write mode, so that the NAND gates NG1 and NG2 respectively transfer the input data DIN and /DIN to the data lines SDL and SDL. When the column select signal "Y" is enabled to high level, the column gate circuit 40 works to connect the data lines SDL and /SDL with the bit lines BL and /BL, so that the input data DIN and /DIN are transferred through the data lines SDL and /SDL and bit lines BL and /BL to be stored into the memory cell 10. On the other hand, when the column select signal "Y" is disabled to low level, the column gate circuit 40 is not operated, so that the data of the data lines SDL and /SDL are not transferred to the memory cell 10. When such a write mode is carried out, the bit lines BL and /BL are maintained with a large voltage difference between the ground voltage and source voltage by the operation of the bit-line sense amplifier.

When the read mode is performed after the write mode, the write control signal φWE is disabled to low logic level, so that the first and second precharge circuits 20 and 30 and the write and precharge circuit 50 work to precharge and equalize the large imbalance of the bit lines BL and /BL. In the read mode where the write control signal φWE is disabled to low logic level, the PMOS transistors M1 and M2 of the first precharge circuit 20 are turned on, and the PMOS transistors M3 and M4 of the second precharge circuit 30 are kept always turned on, so that the bit lines BL and /BL are precharged with the source voltage level. In addition, the PMOS transistors M5 and M6 of the write and precharge circuit 50 are turned on by the write control signal φWE so as to precharge the data lines SDL and /SDL with the source voltage level while the PMOS transistor M7 is turned on by the write control signal φWE to equalise the data lines SDL and /SDL.

Hence, the precharge means does not work in the write mode, but instead is turned on to precharge and equalise the bit and data lines in the read mode. With such precharge means, if the size of the transistor is increased, quick precharging and equalisation of the bit lines are obtained, but the voltage difference of the bit lines is absent in the read mode, disabling the sensing operation of the bit lines, the sizes of the transistors M1-M7 of the precharge means should be small. Consequently, in such conventional semiconductor memory device, there are employed precharge transistors of small size to precharge the bit lines of large capacitances, which requires a precharging time delaying the data access and resulting in imperfect equalisation.

US-A-4802129 describes a RAM with a dual precharge circuit including pair of MOS transistors which precharge a pair of data lines when not in the write mode and a pair of bipolar transistors which respond to effect precharging of the data lines in response to a change in data after the write mode has already been entered, by way of a so-called late data transition pulse.

EP-A2-0608967 describes a memory device in which bit lines and data lines are provided with precharging circuits which operate during address transition. A pair of data lines, that are coupled to a sense amplif ier for reading out data, have a first pair of MOS transistors connected one each between a source voltage and a respective data line, each transistor having a controlling gate terminal connected to common ground for providing a permanent precharging connection irrespective of operation of the sense amplifier and whether data is being read from or written to the memory. The pair of data lines also have a second pair of MOS transistors connected one each between the source voltage and a respective data line, each transistor having a continually gate terminal connected to a precharge control circuit and responsive to a control pulse, generated for a predetermined interval after transition of the circuit from read mode to write mode, to effect precharging in addition to the first pair by conduction of all of these MOS precharging transistors simultaneously. However, insofar as the first pair of transistors are permanently operative irrespective of the operating mode and function of the data lines, control of precharging is confined to the second pair of transistors.

Having regard to the above, it is an object of the present invention to provide a circuit for enabling high speed data access in a semiconductor memory device.

### Summary of the invention

According to the present invention a semiconductor memory device including first and second data lines and a precharging circuit according to the preamble to claim 1 is characterised by a write drive circuit for applying data from data input terminals to the data lines in response to activation of said write control signal, the first and second MOS precharge transistors each having a gate terminal to which the write control signalis applied and being responsive to deactivation of the write control signal to precharge the first and second data lines, and by the third and fourth MOS precharge transistors being relatively larger than the first and second MOS transistors so as to precharge the first and second lines faster than the first and second MOS transistors.

Preferably, the precharge pulse generating means comprises means for delaying the write control signal and for logically combining the write control signal and the delayed write control signal to generate the precharge pulse.

Preferably, the precharge pulse is deactivated before activation of a word line drive signal.

The precharge circuit may further comprise a fifth MOS precharge transistor coupled between the first line and the second line for equalising the precharge on the first and second lines when the write signal is deactivated, and a sixth MOS precharge transistor coupled between the first line and the second line for equalising the precharge on the first and second line when the pulse signal is activated, whereby the fifth and sixth MOS transistors both equalise the precharge on the first and second lines while the pulse signal is activated.

Preferably, the bit lines and data lines are connected by a column select gate responsive to the activation of a column select signal.

Preferably, the device further comprises means for sensing data on the data lines and outputting the sensed data to data output terminals when the write control signal is deactivated.

The bit lines may be connected to a plurality of memory cells in a memory cell array. There may be a plurality of such bit lines, data lines and memory cells.

Preferably, the write drive circuit comprises a pair of NAND gates, each having one input connected to a respective data input terminal, the other input connected to receive the write control signal and its output connected to a respective data line.

Also, according to the present invention a method for precharging a first data line and a second data line forming a data line pair in a semiconductor memory device according to the preamble of claim 10 is characterised by applying data from data input terminals to the data lines in response to activation of the write control signal, applying the write control signal to a gate terminal of the first MOS precharge transistor and precharging the first data line with the first precharge transistor when the write control signal is deactivated, applying the write control signal to a gate terminal of the second MOS precharge transistor and precharging the second data line with the second precharge transistor when the write control signal is deactivated, and causing the third and fourth MOS precharge transistors to precharge the first and second data lines faster than the first and second MOS transistors.

### Brief Description of the Drawings

The present invention will now be described by way of example with reference to the accompanying drawings, in which:
Fig. 1 illustrates a conventional bit-line precharge circuit for a semiconductor memory device;
Fig. 2 illustrates the bit-line precharge circuit of the present invention;
Fig. 3 illustrates the circuit for precharging the data lines in Fig. 2.
Fig. 4 is a graph illustrating the operational characteristics of the essential parts of Fig. 2; and
Figs. 5A and 5B are waveforms illustrating the precharge characteristics of the bit and data lines.

### Brief Description of the Preferred Embodiment

The term "write control signal" φWE represents the write enable signal to activate the write mode, and the term "column select signal" Y represents the signal activated to select a memory cell in the write or read mode. When the column select signal "Y" is activated, the column gate circuit works to connect the bit lines with the data lines. The term "precharge pulse" φPC represents the control signal activated for a given period after deactivation of the write control signal φWE quickly to precharge the data lines at the start of the read mode.

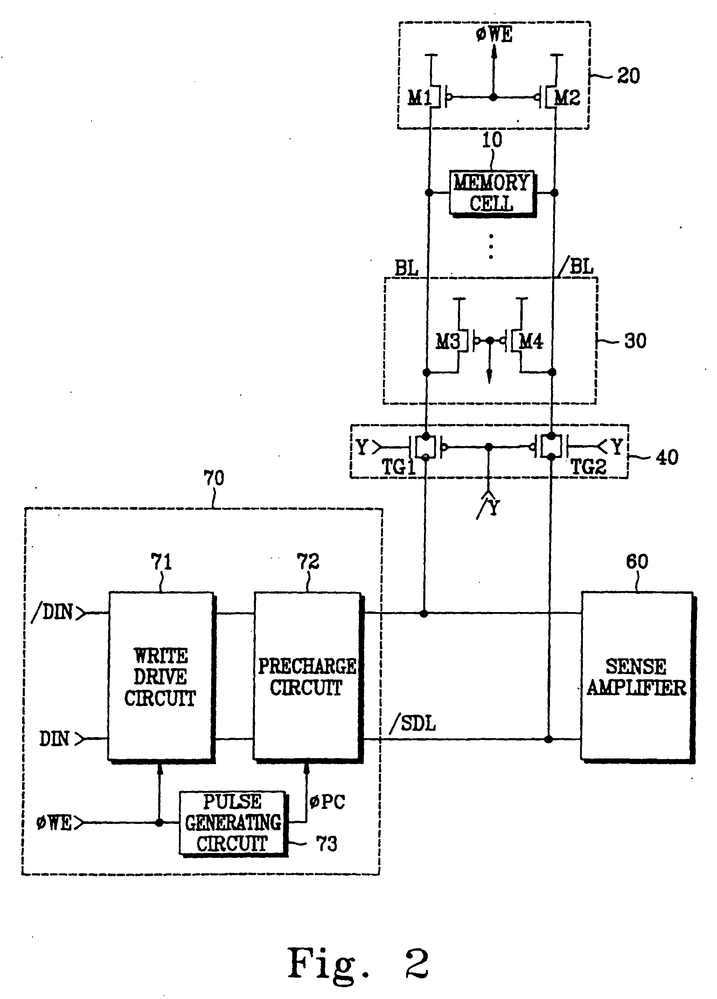

Referring to Fig. 2 where only the write and precharge circuit 70 is shown different from that of Fig. 1, a write drive circuit 71 is provided to transfer external input data DIN and /DIN to the data lines SDL and /SDL on activation of the write control signal φWE. A pulse generating circuit 73 delays the write control signal φWE to generate a precharge pulse φPC. A precharge circuit 72 is connected with the data lines SDL and /SDL with its control terminal connected to the precharge pulse φPC. The precharge circuit 72 precharges the data lines SDL and /SDL with the source voltage for the period of the precharge pulse φPC at the start of the read mode after finishing the write mode.

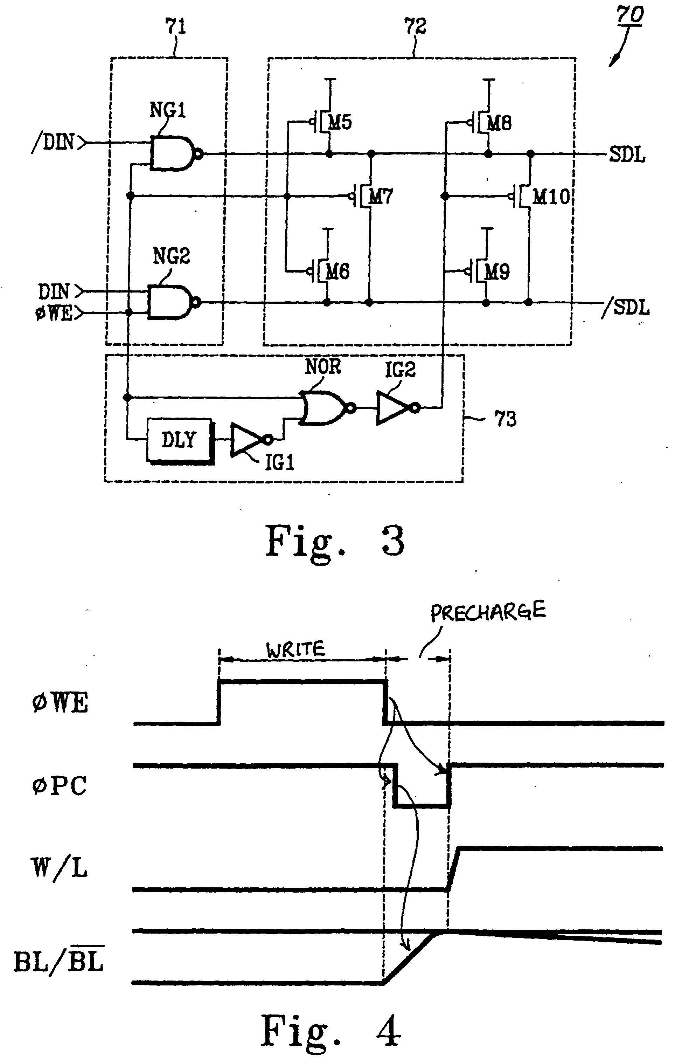

More specifically describing the write and precharge circuit 70 of Fig. 2 with reference to Fig. 3, the write drive circuit 71 transfers the external input data DIN and /DIN to the data lines SDL and /SDL responsive to the write control signal φWE. A NAND gate NG1 logically combines the input data /DIN and write control signal φWE, and NAND gate NG2 the input data DIN and write control signal φWE. The NAND gates NG1 and NG2 write the external input data DIN and /DIN on activation of the write control signal φWE.

A pulse generating circuit 73 generates a pulse signal for a given period at the start of the read mode after the write mode. The pulse generating circuit 73 includes a delay circuit DLY to delay the write control signal φWE. An inverter IG1 inverts the output of the delay circuit DLY. The write control signal φWE and the output of the inverter IG1 are logically combined by a NOR gate NOR to produce a pulse signal maintained for the delay time of the delay circuit DLY after deactivation of the write control signal φWE. An inverter IG2 inverts the output of the NOR gate to produce the precharge pulse signal φPC, which is activated for the delay time of the delay circuit DLY after deactivation of the write control signal φWE.

The precharge circuit 72 precharges the data lines SDL and /SDL with the source voltage level according to the write control signal φWE and precharge pulse φPC in read mode. The precharge circuit 72 has two PMOS transistors M5 and M6 respectively connected between the source voltage and data lines SDL and /SDL with their gates connected to the write control signal φWE, and the PMOS transistor M7 between the data lines SDL and /SDL with its gate also connected to the write control signal φWE. The PMOS transistors M5 and M6 respectively precharge the data lines SDL and /SDL in the read mode where the write control signal φWE is deactivated, and the PMOS transistor M7 equalizes the data lines SDL and /SDL. The PMOS transistors M5 - M7 constitute a first precharge circuit.

Also provided are two PMOS transistors M8 and M9 respectively connected between the source voltage and the data lines SDL and /SDL with their gates connected to the precharge pulse φPC and another PMOS transistor M10 between the data lines SDL and /SDL with its gate connected to the precharge pulse φPC. The PMOS transistors M8 and M9 respectively precharge the data lines SDL and /SDL for a given period from the start of the read mode when the precharge pulse is generated, and the PMOS transistor M10 equalizes the voltages of the data lines SDL and /SDL precharged during the given period. The PMOS transistors M8 - M10 constitute a second precharge circuit of the data lines.

The PMOS transistors M8 - M10 are designed to have larger sizes than the PMOS transistors M5 - M7, so that the second precharge circuit has a greater capacity than the first precharge circuit. The second precharge circuit works while the precharge pulse φPC is activated in the read mode after the write mode. It is preferable to design the period of the precharge pulse φPC to end as the word line drive signal is activated.

Referring to Fig. 4, the precharge pulse φPC has a period between the end of the write control signal φWE and the start of the word line drive signal. In the write mode a voltage difference exists according to the logic levels of the input data DIN and /DIN, when the write control signal φWE is activated to high logic level. Then, the PMOS transistors M1 - M2, M5 - M7, and M8 - M10 of the precharge circuits are turned off so as not to precharge the bit and data lines.

Shifting from the write mode to the read mode, the write control signal φWE is deactivated to low logic signal, as shown in Fig. 4, so that the PMOS transistors M1 - M2 and M5 - M7 of the precharge circuit are turned on to precharge the bit lines BL and /BL and data lines SDL and /SDL. In addition, the delay circuit DLY of the pulse generating circuit 73 delays the write control signal φWE inverted by the inverter IG1. Meanwhile, the NOR gate and inverter IG2 generate the precharge pulse φPC maintained for the delayed time, as shown in Fig. 4. When the precharge pulse φPC is activated to low logic level, the PMOS transistors M8 - M10 are turned on to precharge the data lines SDL and /SDL.

Starting the read mode after the write mode, the PMOS transistors M1 - M2 of the first precharge circuit 20 are turned on, and the PMOS transistors M3 - M4 of the second precharge circuit 30 are always maintained on so as to precharge the bit lines BL and /BL. In addition, the PMOS transistors M5 - M7 of the first precharge circuit of the write and precharge circuit 70 are turned on by the write control signal φWE, and the PMOS transistors M8 - M10 turned on by the precharge pulse φPC, so as to precharge the data lines SDL and /SDL equalized by the PMOS transistors M7 and M10. The precharge signal of the data lines SDL and /SDL is transferred through the column gate circuit 40 to precharge the bit lines BL and /BL. In this case, the sizes of the PMOS transistors M8 - M10 of the second precharge circuit are larger than those of the other precharge circuits, so that the precharging and equalizing of the data lines SDL and /SDL are carried out quickly when the precharge pulse φPC is activated. Thus, the PMOS transistors M8 - M10 of large size precharge the data lines SDL and /SDL and bit lines BL and /BL during the period of the precharge pulse φPC as shown in Fig. 4, never affecting the sensing operation of the bit lines in the read mode.

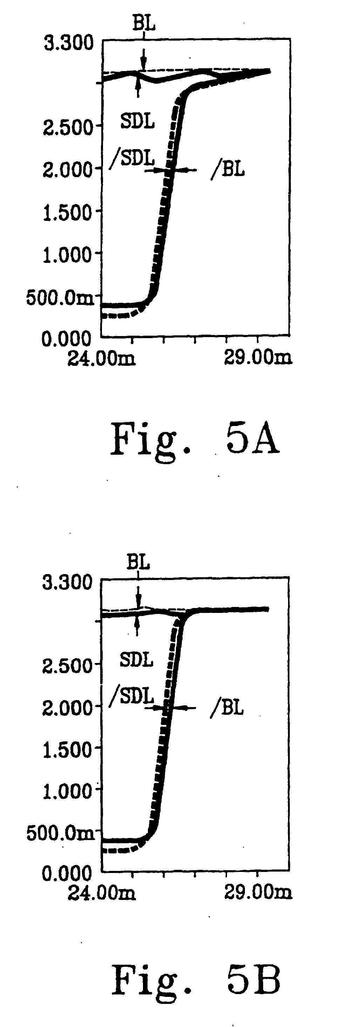

Thus, the circuit according to the present invention precharges the data and bit lines at high speed when shifting from the write mode to the read mode, decreasing the data access time. Thus, as shown in Fig. 5A, the conventional circuit employs the transistors of small sizes to precharge the data and bit lines, so that the precharging time is considerably increased because of the large capacitance of the bit lines so as to increase the data access time. However, the circuit according to the invention as shown in Fig. 5B, works the transistors of large size quickly to precharge the data and bit lines at the start of the read mode after the write mode.

In conclusion, the circuit according to the invention generates a precharge pulse of a given period to activate the precharge means of large size at the end of the write operation, so that the bit lines are precharged and equalized at high speed, decreasing the data access time.

## Claims

1. A semiconductor memory device comprising:
a pair of bit lines (BL,/BL);
a pair of first and second data lines (SDL,/SDL) connected to the bit lines (BL,/BL);
a precharge circuit (72) for precharging the data lines (SDL, /SDL) with a source voltage,
including a first MOS precharge transistor (M5) coupled between said first data line (SDL) and a power supply terminal, for precharging the first data line (SDL);
a second MOS precharge transistor (M6) coupled between said second data line (/SDL) and the power supply terminal for precharging the second data line;
means (73) for generating a precharge pulse signal (φPC) for a predetermined period of time after deactivation of a write control signal (φWE);
a third MOS precharge transistor (M8) coupled between the first data line (SDL) and the power supply terminal for precharging the first data line (SDL) when the pulse signal (φPC) is activated; and
a fourth MOS precharge transistor (M9) coupled between the second data line (/SDL) and the power supply terminal for precharging the second data line (/SDL) when the pulse signal (φPC) is activated;
whereby the first, second, third and fourth MOS transistors (M5, M6, M8, M9) all precharge simultaneously while the pulse signal (φPC) is activated;
**characterised by**:
a write drive circuit (71) for applying data from data input terminals (DIN, /DIN) to the data lines (SDL,/SDL) in response to activation of said write control signal (φWE);
the first (M5) and second (M6) MOS precharge transistors each having a gate terminal to which the write control signal (φWE) is applied and being responsive to deactivation of the write control signal to precharge the first and second data lines; and by
the third (M8) and fourth (M9) MOS precharge transistors (M8, M9) being relatively larger than the first and second MOS transistors (M5, M6) so as to precharge the first and second data lines (SDL, /SDL) faster than the first and second MOS transistors.

2. A device according to claim 1 in which the precharge pulse generating means (73) comprises means (DLY, IGI, NOR, IG2) for delaying the write control signal (φWE) and for logically combining the write control signal (φWE) and the delayed write control signal to generate the precharge pulse (φPC).

3. A device according to claim 1 or claim 2 in which the precharge pulse (φPC) is deactivated before activation of a word line drive signal.

4. A device according to any preceding claim in which the precharge circuit further comprises:
a fifth MOS precharge transistor (M7) coupled between the first data line (SDL) and the second data line (/SDL) for equalising the precharge on the first and second data lines (SDL, /SDL) when the write signal (φWE) is deactivated; and
a sixth MOS precharge transistor (M10) coupled between the first data line (SDL) and the second data line (/SDL) for equalising the precharge on the first and second data lines (SDL, /SDL) when the pulse signal (φPC) is activated;
whereby the fifth and sixth MOS transistors (M7, M10) both equalise the precharge on the first and second data lines (SDL, /SDL) while the pulse signal (φPC) is activated.

5. A device according to any preceding claim in which the bit lines (BL, /BL) and data lines (SDL, /SDL) are connected by a column select gate (40) responsive to the activation of a column select signal (IY).

6. A device according to any preceding claim further comprising means (60) for sensing data on the data lines (SDL, /SDL) and outputting the sensed data to data output terminals when the write control signal (φWE) is deactivated.

7. A device according to any preceding claim in which the bit line (BL) is connected to a plurality of memory cells (10) in a memory cell array.

8. A device according to claim 7 in which there is a plurality of such bit lines (BL), data lines (SDL) and memory cells (10).

9. A device according to any preceding claim in which the write drive circuit (71) comprises a pair of NAND gates (NG1, NG2), each having one input connected to a respective data input terminal (DIN, /DIN), the other input connected to receive the write control signal (φWE) and its output connected to a respective data line (SDL, /SDL).

10. A method for precharging a first data line (SDL) and a second data line (/SDL) forming a data line pair in a semiconductor memory device, the method comprising
generating a precharge pulse signal (φPC) for a predetermined period of time after deactivation of a write control signal (φWE);
precharging the first data line with a first MOS precharge transistor (M5);
precharging the second data line with a second MOS precharge transistor (M6);
precharging the first data line with a third MOS precharge transistor (M8) when the pulse signal (φPC) is activated;
precharging the second data line with a fourth MOS precharge transistor (M9) when the pulse signal (φPC) is activated;
whereby the first, second third and fourth MOS precharge transistors charge simultaneously while the pulse signal (φPC) is activated; and **characterised by**
applying data from data input terminals (DIN, /DIN) to the data lines in response to activation of the write control signal (φWE);
applying the write control signal to a gate terminal of the first MOS precharge transistor (M5) and precharging the first data line (SDL) with the first precharge transistor when the write control signal (φWE) is deactivated;
applying the write control signal to a gate terminal of the second MOS precharge transistor (M6) and precharging the second data line (/SDL) with the second precharge transistor when the write control signal (φWE) is deactivated; and
causing the third and fourth MOS precharge transistors (M8, M9) to precharge the first and second data lines (SDL,/SDL) faster than the first and second MOS transistors (M5, M6).

## Patentansprüche

1. Halbleiter-Speichervorrichtung enthaltend:
ein Paar Bitleitungen (BL,/BL);
ein Paar erste und zweite Datenleitungen (SDL,/SDL), die mit den Bitleitungen (BL,/BL) verbunden sind;
eine Vorladeschaltung (72) zum Vorladen der Datenleitungen (SDL,/SDL) mit einer Versorgungsspannung,
weiterhin enthaltend einen ersten zwischen der ersten Datenleitung (SDL) und einem Energieversorgungsanschluss geschalteten MOS-Vorladetransistor (M5) zum Vorladen der ersten Datenleitung (SDL);
einen zweiten zwischen der zweiten Datenleitung (/SDL) und dem Energieversorgungsanschluss geschalteten MOS-Vorladetransistor (M6) zum Vorladen der zweiten Datenleitung;
Mittel (73) zum Erzeugen eines Vorladeimpulssignals (φ PC) für eine vorbestimmte Zeitdauer nach Deaktivierung eines Schreibsteuersignals (φ WE);
einen Dritten zwischen der ersten Datenleitung (SDL) und dem Energieversorgungsanschluss geschalteten MOS-Vorladetransistor (M8) zum Vorladen der ersten Datenleitung (SDL), wenn das Impulssignal (φ PC) aktiviert ist; und
einen vierten zwischen der zweiten Datenleitung (/SDL) und dem Energieversorgungsanschluss geschalteten MOS-Vorladetransistor (M9) zum Vorladen der zweiten Datenleitung (/SDL), wenn das Impulssignal (φ PC) aktiviert ist;
wobei der erste, der zweite, der dritte und der vierte MOS-Transitor (M5, M6, M8, M9) gleichzeitig vorladen, während das Impulssignal (φ PC) aktiviert ist;
**gekennzeichnet durch**:
eine Schreibantriebsschaltung (71), um Daten von Dateneingabeanschlüssen (DIN,/DIN) den Datenleitungen (SDL,/SDL) in Erwiderung auf die Aktivierung des Schreibsteuersignals (φ WE) zu zuführen;
wobei der erste und der zweite MOS-Vorladetransistor (M5, M6) jeweils einen Gate-Anschluss aufweisen, an den das Schreibsteuersignal (φ WE) angelegt wird, und wobei der erste und der zweite MOS-Vorladetransistor (M5, M6) auf die Deaktivierung des Schreibsteuersignals reagieren, um die erste und die zweite Datenleitung vorzuladen; und
wobei der dritte und der vierte MOS-Vorladetransistor (M8, M9) verhältnismäßig größer sind als der erste und der zweite MOS-Transistor (M5, M6), um so die erste und die zweite Datenleitung (SDL,/SDL) schneller vorzuladen als der erste und der zweite MOS-Transistor.

2. Vorrichtung nach Anspruch 1,
bei der die Vorlade-Impulserzeugungsmittel (73) Mittel (DLY, IG1, NOR, IG2) zum Verzögern des Schreibsteuersignals (φ WE) und zum logischen Verbinden des Schreibsteuersignals (φ WE) mit dem verzögerten Schreibsteuersignal enthalten, um den Vorladeimpuls (φ PC) zu erzeugen.

3. Vorrichtung nach Anspruch 1 oder 2,
bei der der Vorladeimpuls (φ PC) vor Aktivierung eines Wortzeilen-Antriebssignals deaktiviert wird.

4. Vorrichtung nach einem der vorstehenden Ansprüche,
bei der die Vorladeschaltung weiterhin enthält:
einen fünften MOS-Vorladetransitor (M7), der zwischen der ersten Datenleitung (SDL) und der zweiten Datenleitung (/SDL) zum Angleichen der Vorladung an der ersten und
der zweiten Datenleitung (SDL,/SDL), wenn das Schreibsignal (φ WE) deaktiviert ist, geschaltet ist; und
einen sechsten MOS-Vorladetransistor (M10), der zwischen der ersten Datenleitung (SDL) und der zweiten Datenleitung (/SDL) zum Angleichen der Vorladung an der ersten und der zweiten Datenleitung (SDL,/SDL), wenn das Impulssignal (φ PC) aktiviert ist, geschaltet ist;
wobei der fünfte und der sechste MOS-Transistor (M7, M10) beide die Vorladung an der ersten und der zweiten Datenleitung (SDL,/SDL) angleichen, während das Impulssignal (φ PC) aktiviert ist,

5. Vorrichtung nach einem der vorstehenden Ansprüche,
bei der die Bitleitungen (BL,/BL) und die Datenleitungen (SDL,/SDL) durch ein Spaltenauswahlgate (40) verbunden sind, welches auf die Aktivierung eines Spaltenauswahlsignals (IY) reagiert.

6. Vorrichtung nach einem der vorstehenden Ansprüche,
weiterhin enthaltend Mittel (60) zum Erfassen von Daten auf den Datenleitungen (SDL,/SDL) und zum Ausgeben der erfassten Daten an Datenausgabeanschlüsse wenn das Schreibsteuersignal (φ WE) deaktiviert ist.

7. Vorrichtung nach einem der vorstehenden Ansprüche,
bei der die Bitleitung (BL) mit einer Vielzahl an Speicherzellen (10) in einem Speicherzellenarray verbunden ist.

8. Vorrichtung nach Anspruch 7,
bei der eine Vielzahl an derartigen Bitleitungen (BL), Datenleitungen (SDL) und Speicherzellen (10) vorgesehen ist.

9. Vorrichtung nach einem der vorstehenden Ansprüche,
bei der die Schreibsteuerschaltung (71) ein Paar NAND-Gates (NG1, NG2) aufweist, von denen jedes einen Eingang besitzt, der mit einem entsprechenden Dateneingabeanschluss (DIN,/DIN) verbunden ist, wobei der andere Eingang verbunden ist, um das Schreibsteuersignal (φ WE) zu empfangen, und der Ausgang mit einer entsprechenden Datenleitung (SDL,/SDL) verbunden ist.

10. Verfahren zum Vorladen einer ersten Datenleitungen (SDL) und einer zweiten Datenleitung (/SDL), die ein Datenleitungspaar in einer Halbleiterspeichervorrichtung zu bilden,
wobei das Verfahren enthält:
Erzeugen eines Vorladeimpulssignals (φ PC) für eine vorbestimmte Zeitperiode nach Deaktivierung eines Schreibsteuersignals (φ WE);
Vorladen der ersten Datenleitung mit einem ersten MOS-Vorladetransistor (M5);
Vorladen der zweiten Datenleitung mit einem zweiten MOS-Vorladetransistor (M6);
Vorladen der ersten Datenleitung mit einem dritten MOS-Vorladetransistor (M8), wenn das Impulssignal (φ PC) aktiviert ist;
Vorladen der zweiten Datenleitung mit einem vierten MOS-Vorladetransistor (M9), wenn das Impulssignal (φ PC) aktiviert ist; wobei der erste, der zweite, der dritte und der vierte MOS-Vorladetransistor gleichzeitig laden während das Impulssignal (φ PC) aktiviert ist;
und **gekennzeichnet durch**
Zuführen von Daten von Dateneingabeanschlüssen (DIN,/DIN) zu den Datenleitungen in Erwiderung auf die Aktivierung des Schreibsteuersignals (φ WE);
Anlegen des Schreibsteuersignals an einen Gateanschluss des ersten MOS-Vorladetransistors (M5) und Vorladen der ersten Datenleitung (SDL) mit dem ersten Vorladetransistor, wenn das Schreibsteuersignal (φ WE) deaktiviert ist; und
Anlegen des Schreibsteuersignals an einen Gateanschluss des zweiten MOS-Vorladetransistors (M6) und Vorladen der zweiten Datenleitung (,/SDL) mit dem zweiten Vorladetransistor, wenn das Schreibsteuersignal (φ WE) deaktiviert ist;
wobei der dritte und der vierte MOS-Vorladetransistor (M8, M9) veranlasst werden, die erste und die zweite Datenleitung (SDU, SDL) schneller als der erste und der zweite MOS-Transistor (M5, M6) vorzuladen.

## Revendications

1. Dispositif de mémoire à semi-conducteurs comprenant :
une paire de lignes de bits (BL, /BL) ;
une paire de première et seconde lignes de données (SDL, /SDL) connectées aux lignes de bits (BL, /BL);
un circuit de précharge (72) pour précharger les lignes de données (SDL, /SDL) avec une tension de source,
comprenant un premier transistor MOS de précharge (M5) couplé entre ladite première ligne de données (SDL) et une borne d'alimentation électrique, pour précharger la première ligne de données (SDL) ;
un deuxième transistor MOS de précharge (M6) couplé entre ladite seconde ligne de données (/SDL) et la borne d'alimentation électrique pour précharger la seconde ligne de données ;
un moyen (73) pour générer un signal impulsionnel de précharge (φPC) pendant une durée prédéterminée après la désactivation d'un signal de commande d'écriture (φWE) ;
un troisième transistor MOS de précharge (M8) couplé entre la première ligne de données (SDL) et la borne d'alimentation électrique pour précharger la première ligne de données (SDL) lorsque le signal impulsionnel (φPC) est activé ; et
un quatrième transistor MOS de précharge (M9) couplé entre la seconde ligne de données (/SDL) et la borne d'alimentation électrique pour précharger la seconde ligne de données (/SDL) lorsque le signal impulsionnel (φPC) est activé ;
moyennant quoi les premier, deuxième, troisième et quatrième transistors MOS (M5, M6, M8, M9) préchargent tous simultanément alors que le signal impulsionnel (φPC) est activé ;
**caractérisé par**
un circuit d'attaque d'écriture (71) pour appliquer les données provenant des bornes d'entrée de données (DIN, /DIN) aux lignes de données (SDL, /SDL) en réponse à l'activation dudit signal de commande d'écriture (φWE) ;
les premier (M5) et deuxième (M6) transistors MOS de précharge ayant chacun une borne de grille sur laquelle le signal de commande d'écriture (φWE) est appliqué et étant sensible à la désactivation du signal de commande d'écriture pour précharger les première et seconde lignes de données ; et par
les troisième (M8) et quatrième (M9) transistors MOS de précharge (M8, M9) étant relativement plus grands que les premier et deuxième transistors MOS (M5, M6) de façon à précharger les première et seconde lignes de données (SDL, /SDL) plus rapidement que les premier et deuxième transistors MOS.

2. Dispositif selon la revendication 1, dans lequel le moyen de génération d'impulsion de précharge (73) comprend un moyen (DLY, IGI, NOR, IG2) pour retarder le signal de commande d'écriture (φWE) et pour combiner logiquement le signal de commande d'écriture (φWE) et le signal de commande d'écriture retardé pour générer l'impulsion de précharge (φPC).

3. Dispositif selon la revendication 1 ou 2, dans lequel l'impulsion de précharge (φPC) est désactivée avant l'activation d'un signal d'attaque de lignes de mot.

4. Dispositif selon l'une quelconque des revendications précédentes, dans lequel le circuit de précharge comprend, en outre :
un cinquième transistor MOS de précharge (M7) couplé entre la première ligne de données (SDL) et la seconde ligne de données (/SDL) pour égaliser la précharge sur les première et seconde lignes de données (SDL, /SDL) pour égaliser la précharge sur les première et seconde lignes de données (SDL, /SDL) lorsque le signal d'écriture (φWE) est désactivé ; et
un sixième transistor MOS de précharge (M10) couplé entre la première ligne de données (SDL) et la seconde ligne de données (/SDL) pour égaliser la précharge sur les première et seconde lignes de données (SDL, /SDL) lorsque le signal impulsionnel (φPC) est activé ;
moyennant quoi les cinquième et sixième transistors MOS (M7, M10) égalisent tous les deux la précharge sur les première et seconde lignes de données (SDL, /SDL) alors que le signal impulsionnel (φPC) est activé.

5. Dispositif selon l'une quelconque des revendications précédentes, dans lequel les lignes de bits (BL, /BL) et les lignes de données (SDL, /SDL) sont connectées par une porte de sélection de colonnes (40) sensible à l'activation d'un signal de sélection de colonnes (IY).

6. Dispositif selon l'une quelconque des revendications précédentes, comprenant, en outre, un moyen (60) pour détecter les données sur les lignes de données (SDL, /SDL) et pour sortir les données détectées vers les bornes de sortie de données lorsque le signal de commande d'écriture (φWE) est désactivé.

7. Dispositif selon l'une quelconque des revendications précédentes, dans lequel la ligne de bits (BL) est connectée à une pluralité de cellules mémoire (10) dans une matrice de cellules mémoire.

8. Dispositif selon la revendication 7, dans lequel il existe une pluralité de ces lignes de bits (BL), lignes de données (SBL) et cellules mémoire (10).

9. Dispositif selon l'une quelconque des revendications précédentes, dans lequel le circuit d'attaque d'écriture (71) comprend une paire de portes NAND (NG1, NG2), chacune ayant une entrée connectée à une borne d'entrée de données respective (DIN, /DIN), l'autre entrée connectée pour recevoir le signal de commande d'écriture (φWE) et sa sortie connectée à une ligne de données respective (SDL, /SDL) .

10. Procédé pour précharger une première ligne de données (SDL) et une seconde ligne de données (/SDL) formant une paire de lignes de données dans un dispositif de mémoire à semi-conducteurs, le procédé comprenant les étapes consistant à
générer un signal impulsionnel de précharge (φPC) pendant une durée prédéterminée après désactivation d'un signal de commande d'écriture (φWE) ;
précharger la première ligne de données avec un premier transistor MOS de précharge (M5) ;
précharger la seconde ligne de données avec un deuxième transistor MOS de précharge (M6) ;
précharger la première ligne de données avec un troisième transistor MOS de précharge (M8) lorsque le signal impulsionnel (φPC) est activé ;
précharger la seconde ligne de données avec un quatrième transistor MOS de précharge (M9) lorsque le signal impulsionnel (φPC) est activé ;
moyennant quoi, les premier, deuxième, troisième et quatrième transistors MOS de précharge chargent simultanément alors que le signal impulsionnel (φPC) est activé ; et **caractérisé par** les étapes consistant à
appliquer les données provenant des bornes d'entrée de données (DIN, /DIN) aux lignes de données en réponse à l'activation du signal de commande d'écriture (φWE) ;
appliquer le signal de commande d'écriture à une borne de grille du premier transistor MOS de précharge (M5) et précharger la première ligne de données (SDL) avec le premier transistor de précharge lorsque le signal de commande d'écriture (φWE) est désactivé ;
appliquer le signal de commande d'écriture à une borne de grille du deuxième transistor MOS de précharge (M6) et précharger la seconde ligne de données (/SDL) avec le deuxième transistor de précharge lorsque le signal de commande d'écriture (φWE) est désactivé ; et
amener les troisième et quatrième transistors MOS de précharge (M8, M9) à précharger les première et seconde lignes de données (SDL, /SDL) plus rapidement que les premier et deuxième transistors MOS (M5, M6).
